# EUROPEAN PATENT APPLICATION

(11) **EP 4 836 314 A1**
(43) Date of publication of application: **04.11.2026**
(21) Application number: 24913551.8
(22) Date of filing: 03.12.2024
(51) Int. Cl.: H04B 7/155, H03D 7/16

(54) **WIRELESS RELAY DEVICE USING LINK FREQUENCY AND OPERATION METHOD THEREOF**

(30) Priority: 28.12.2023 KR 20230194073
(71) Applicant: E-Umtech Inc., Anyang-si Gyeonggi-do 14055 (KR); Seong, Kyoung Hwan, Hanam-si Gyeonggi-do 12916 (KR)
(72) Inventor: SEONG, Kyoung Hwan, Hanam-si Gyeonggi-do 12916 (KR)
(74) Representative: Jung, Minkyu
(86) International application number: PCT/KR2024/019579
(87) International publication number: WO 2025/143608

(57) **Abstract**

A method of operating a wireless relay apparatus provided by an embodiment of the present invention includes: (a) receiving a downlink signal as input; (b) determining a frequency of a first signal to be output as one link frequency, which is different from a frequency of the downlink signal, among a plurality of preset link frequencies; and (c) outputting, by using the input downlink signal, a first signal having the determined link frequency and a second signal having a service frequency of a base station.

## Description

### Technical Field

The present invention relates to a wireless relay apparatus using a link frequency and a method of operating the same.

### Background Art

A wireless signal relay apparatus (hereinafter, may be abbreviated as a 'wireless relay apparatus', a 'relay apparatus' or a 'repeater') performs a function of receiving a wireless signal in a wireless communication system and amplifying and retransmitting the wireless signal.

The wireless relay apparatus may be used in various wireless communication technologies. For example, in mobile communication networks such as LTE (long term evolution) and 5G (Generation) NR (New Radio), a wireless signal relay apparatus is used to expand a communication range and improve signal quality. In addition, in a satellite communication system, a relay apparatus enables wireless communication between the earth and a satellite. In addition to these, relay apparatuses play an important role in various fields such as wireless networks, wireless communication systems and wireless power transmission.

In general, the frequency of a signal input to an input antenna of a relay apparatus and the frequency of a signal output from an output antenna coincide with each other. Meanwhile, a signal output from the output antenna may be fed back to the input antenna. Due to such a feedback signal, if the degree of isolation between the output antenna and the input antenna provided in the relay apparatus is not very large compared to the overall gain of the relay apparatus, oscillation occurs in the relay apparatus due to the feedback signal, so that the relay apparatus cannot perform the intended signal transfer.

### Disclosure of Invention

### Technical Problem

An embodiment of the present invention proposes a scheme for preventing oscillation from occurring in a wireless relay apparatus.

An embodiment of the present invention proposes a scheme for setting a frequency of an input signal and a frequency of an output signal differently in a wireless relay apparatus.

An embodiment of the present invention proposes a scheme for determining a frequency of an output signal with respect to a downlink signal in a wireless relay apparatus.

An embodiment of the present invention proposes a scheme for determining a frequency of an output signal when an uplink signal is input in a wireless relay apparatus.

### Solution to Problem

A method of operating a wireless relay apparatus provided by an embodiment of the present invention includes: (a) receiving a downlink signal as input; (b) determining a frequency of a first signal to be output as one link frequency, which is different from a frequency of the downlink signal, among a plurality of preset link frequencies; and (c) outputting, by using the input downlink signal, a first signal having the determined link frequency and a second signal having a service frequency of a base station.

Here, the step (b) is characterized in that, if the frequency of the input downlink signal is the service frequency, the frequency of the first signal is determined as one of the plurality of preset link frequencies.

Here, the step (c) includes: converting the downlink signal of the service frequency into a signal of an intermediate frequency; frequency up-converting the converted signal of the intermediate frequency into the second signal of the service frequency; and frequency up-converting the converted signal of the intermediate frequency into the first signal of the determined link frequency.

Here, the step (b) is characterized in that, if the frequency of the input downlink signal is one of the plurality of preset link frequencies, the frequency of the first signal is determined as one of link frequencies, which are not the frequency of the input downlink signal, among the plurality of preset link frequencies.

Here, the step (c) includes: converting the input downlink signal into a signal of an intermediate frequency; frequency up-converting the converted signal of the intermediate frequency into the second signal of the service frequency; and frequency up-converting the converted signal of the intermediate frequency into the first signal of the determined link frequency.

A wireless relay apparatus provided by an embodiment of the present invention includes: a communication unit which receives a downlink signal as input; and a processor which determines a frequency of a first signal to be output as one link frequency, which is different from a frequency of the downlink signal, among a plurality of preset link frequencies, generates, by using the input downlink signal, a first signal having the determined link frequency and a second signal having a service frequency of a base station, and outputs the first signal and the second signal through the communication unit.

Here, if the frequency of the input downlink signal is the service frequency, the processor determines the frequency of the first signal as one of the plurality of preset link frequencies.

Here, the communication unit includes: a down converter which converts the downlink signal of the service frequency into a signal of an intermediate frequency; a first up converter which frequency up-converts the converted signal of the intermediate frequency into the second signal of the service frequency; and a second up converter which frequency up-converts the converted signal of the intermediate frequency into the first signal of the determined link frequency.

Here, if the frequency of the input downlink signal is one of the plurality of preset link frequencies, the processor determines the frequency of the first signal as one of link frequencies, which are not the frequency of the input downlink signal, among the plurality of preset link frequencies.

Here, the communication unit includes: a down converter which converts the input downlink signal into a signal of an intermediate frequency; a first up converter which frequency up-converts the converted signal of the intermediate frequency into the second signal of the service frequency; and a second up converter which frequency up-converts the converted signal of the intermediate frequency into the first signal of the determined link frequency.

A method of operating a wireless relay apparatus provided by an embodiment of the present invention includes: (a) receiving, as input, a first uplink signal of a service frequency of a base station and a second uplink signal of a first link frequency, which is one of a plurality of preset link frequencies, relayed from another relay apparatus; (b) determining a frequency of an output signal based on whether the wireless relay apparatus is a last wireless relay apparatus; and (c) generating an output signal of the determined frequency by using the first uplink signal and the second uplink signal, wherein the last wireless relay apparatus directly transfers an output signal of the wireless relay apparatus to the base station without relaying by another wireless relay apparatus.

Here, the step (b) includes a step of determining, if the wireless relay apparatus is the last wireless relay apparatus, the frequency of the output signal as the service frequency.

Here, the step (c) includes: converting the first uplink signal into a first intermediate signal of an intermediate frequency; frequency up-converting the first intermediate signal into a signal of the service frequency; converting the second uplink signal into a second intermediate signal of an intermediate frequency; and frequency up-converting the second intermediate signal into a signal of the service frequency.

Here, the step (b) includes a step of determining, if the wireless relay apparatus is not the last wireless relay apparatus, the frequency of the output signal as a second link frequency, which is not the first link frequency, among the plurality of preset link frequencies.

Here, the step (c) includes: converting the first uplink signal into a first intermediate signal of an intermediate frequency; frequency up-converting the first intermediate signal into a signal of the determined second link frequency; converting the second uplink signal into a second intermediate signal of an intermediate frequency; and frequency up-converting the second intermediate signal into a signal of the determined second link frequency.

A wireless relay apparatus provided by an embodiment of the present invention includes: a communication unit which receives, as input, a first uplink signal of a service frequency of a base station and a second uplink signal of a first link frequency, which is one of preset link frequencies, relayed from another relay apparatus; and a processor which determines a frequency of an output signal based on whether the wireless relay apparatus is a last wireless relay apparatus, generates an output signal of the determined frequency by using the first uplink signal and the second uplink signal, and outputs the output signal through the communication unit, wherein the last wireless relay apparatus directly transfers an output signal of the wireless relay apparatus to the base station without relaying by another wireless relay apparatus.

Here, if the wireless relay apparatus is the last wireless relay apparatus, the processor determines the frequency of the output signal as the service frequency.

Here, the communication unit includes: a first down converter which converts the first uplink signal into a first intermediate signal of an intermediate frequency; an up converter which frequency up-converts the first intermediate signal into a signal of the service frequency; a second down converter which converts the second uplink signal into a second intermediate signal of an intermediate frequency; and the up converter which frequency up-converts the second intermediate signal into a signal of the service frequency.

Here, if the wireless relay apparatus is not the last wireless relay apparatus, the processor determines the frequency of the output signal as a second link frequency, which is not the first link frequency, among the plurality of preset link frequencies.

Here, the communication unit includes: a first down converter which converts the first uplink signal into a first intermediate signal of an intermediate frequency; an up converter which frequency up-converts the first intermediate signal into a signal of the determined second link frequency; a second down converter which converts the second uplink signal into a second intermediate signal of an intermediate frequency; and the up converter which frequency up-converts the second intermediate signal into a signal of the determined second link frequency.

### Advantageous Effects of Invention

According to embodiments of the present invention, by making a frequency of an input signal and a frequency of an output signal different by using a link frequency in a wireless relay apparatus so that oscillation does not occur in the wireless relay apparatus due to an infinite loop caused by feedback of the output signal, the wireless relay apparatus can stably relay a wireless signal.

Effects that can be obtained through specific examples of the present specification are not limited to the effects listed above. For example, there may exist various technical effects that a person having ordinary skill in the related art can understand or derive from the present specification. Accordingly, the specific effects of the present specification are not limited to those explicitly described in the present specification, and may include various effects that can be understood or derived from the technical features of the present specification.

### Brief Description of Drawings

The following drawings were prepared to explain specific examples of the present specification. Since the names of specific apparatuses or the names of specific signals/messages/fields described in the drawings are presented by way of example, the technical features of the present specification are not limited to the specific names used in the following drawings.
FIG. 1 is a diagram explaining oscillation that may occur in a wireless relay apparatus depending on the relationship between feedback isolation and gain.
FIG. 2 is a diagram explaining a feedback signal and oscillation in a case where frequencies of an input signal and an output signal of a wireless relay apparatus are different.
FIG. 3 is a diagram explaining a configuration of a wireless relay apparatus which restores a frequency of an output signal in a case where frequencies of an input signal and an output signal are different.
FIG. 4a and FIG. 4b are diagrams explaining a concept of wireless relaying according to an embodiment of the present invention.
FIG. 5a is a diagram explaining a configuration of a wireless relay apparatus according to an embodiment of the present invention and an operation in a case where an input frequency in a forward direction is a service frequency.
FIG. 5b is a diagram explaining an operation in a case where an input frequency in the forward direction in the wireless relay apparatus according to an embodiment of the present invention is a first frequency.
FIG. 5c is a diagram explaining an operation in a case where an input frequency in the forward direction in the wireless relay apparatus according to an embodiment of the present invention is a second frequency.
FIG. 6a is a diagram explaining an operation in a case where input frequencies in a reverse direction in the wireless relay apparatus according to an embodiment of the present invention are the service frequency and the first frequency.
FIG. 6b is a diagram explaining an operation in a case where input frequencies in the reverse direction in the wireless relay apparatus according to an embodiment of the present invention are the service frequency and the second frequency.
FIG. 7 is a diagram explaining an operation of a wireless relay apparatus which has received a forward signal according to an embodiment of the present invention.
FIG. 8 is a diagram explaining an operation of a wireless relay apparatus which has received a reverse signal according to an embodiment of the present invention.
FIG. 9 is a diagram explaining a configuration of a wireless relay apparatus according to an embodiment of the present invention.

### Mode for the Invention

Since the present invention may have various modifications and may have various embodiments, specific embodiments are illustrated in the drawings and described in detail in the detailed description. However, this is not intended to limit the present invention to the specific embodiments, and it should be understood that all modifications, equivalents and substitutes included in the spirit and technical scope of the present invention are included. In describing each drawing, similar reference numerals are used for similar components.

Terms such as "first", "second", "A" and "B" may be used in the present specification to describe various components, but the components should not be limited by the terms. The terms are used only for the purpose of distinguishing one component from another component. For example, without departing from the scope of rights of the present invention, a first component may be named a second component, and similarly, a second component may also be named a first component. In addition, the term "and/or" includes a combination of a plurality of related described items or any one item of the plurality of related described items.

When a component is referred to as being "connected" or "coupled" to another component, it should be understood that the component may be directly connected or coupled to the other component, but another component may exist in between. On the other hand, when a component is referred to as being "directly connected" or "directly coupled" to another component, it should be understood that no other component exists in between.

The terms used in the present specification are used only to describe specific embodiments, and are not intended to limit the present invention. A singular expression includes a plural expression unless the context clearly dictates otherwise. In the present specification, terms such as "comprise" or "have" are intended to designate that features, numbers, steps, operations, components, parts or combinations thereof described in the specification exist, and it should be understood that the possibility of existence or addition of one or more other features, numbers, steps, operations, components, parts or combinations thereof is not precluded in advance.

Unless defined otherwise, terms used in the present specification, including technical or scientific terms, have the same meanings as those generally understood by a person having ordinary skill in the technical field to which the present invention belongs. Terms such as those defined in commonly used dictionaries should be interpreted as having meanings consistent with the meanings possessed in the context of the related art, and unless explicitly defined in the present specification, are not interpreted in ideal or excessively formal meanings.

Prior to the detailed description of the drawings, it is intended to clarify that the division of components in the present specification is merely a division by the main function each component is responsible for. That is, two or more components to be described below may be combined into one component, or one component may be divided into two or more components for each more subdivided function.

In addition, each of the components to be described below may additionally perform some or all of the functions that other components are responsible for in addition to the main function that the component itself is responsible for, and some of the main functions that each component is responsible for may be exclusively performed by other components. Therefore, the existence or non-existence of each component described throughout the present specification should be interpreted functionally.

In the present specification, "A or B" may mean "only A", "only B" or "both A and B". In other words, in the present specification, "A or B" may be interpreted as "A and/or B". For example, in the present specification, "A, B or C" may mean "only A", "only B", "only C", or "any combination of A, B and C".

A slash (/) or a comma used in the present specification may mean "and/or". For example, "A/B" may mean "A and/or B". Accordingly, "A/B" may mean "only A", "only B", or "both A and B". For example, "A, B, C" may mean "A, B or C".

In the present specification, "at least one of A and B" may mean "only A", "only B" or "both A and B". In addition, in the present specification, the expression "at least one of A or B" or "at least one of A and/or B" may be interpreted the same as "at least one of A and B".

In addition, in the present specification, "at least one of A, B and C" may mean "only A", "only B", "only C", or "any combination of A, B and C". In addition, "at least one of A, B or C" or "at least one of A, B and/or C" may mean "at least one of A, B and C". Hereinafter, embodiments according to the present invention will be described in detail with reference to the accompanying drawings.

Prior to the description of the embodiments of the present invention, oscillation that may occur in a wireless relay apparatus is described.

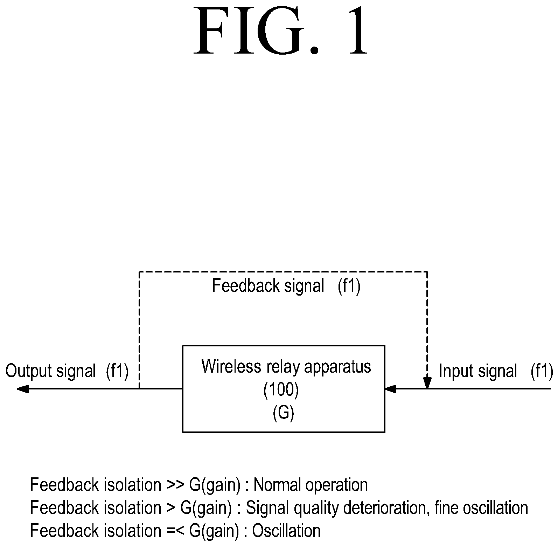

FIG. 1 is a diagram explaining oscillation that may occur in a wireless relay apparatus depending on the relationship between feedback isolation and gain.

Referring to FIG. 1, G denotes the overall system gain of the wireless relay apparatus 100. The wireless relay apparatus 100 receives a signal of frequency f1 as input through an input antenna (not shown), amplifies the input signal according to the gain G, and outputs a signal of frequency f1 through an output antenna (not shown). In a typical case, the frequencies of the input signal and the output signal are the same. In FIG. 1, the frequencies of the input signal and the output signal were assumed to be f1.

In a general wireless relay apparatus, if the isolation of the path fed back from the output side to the input side is not sufficiently larger than the overall system gain (G), the output signal may flow into the input side of the wireless relay apparatus 100. This is referred to as a feedback signal. Since the feedback signal is a part of the output signal, the frequency of the feedback signal becomes f1. Such a feedback signal is amplified and output again by the wireless relay apparatus 100, and an infinite loop may occur by the manner in which a part thereof is fed back again. When an infinite loop due to such a feedback signal occurs, signal quality deteriorates or oscillation occurs, so that the wireless relay apparatus 100 cannot normally perform signal relaying. Here, 'oscillation' is a phenomenon in which an unwanted signal is generated in an electronic device. However, whether oscillation occurs may be determined according to the system gain (G) of the wireless relay apparatus and the feedback isolation. Here, the feedback isolation may be determined based on the physical distance between the input terminal and the output terminal to minimize signal interference, the environment of the wireless channel, and the like.

When the feedback isolation is sufficiently larger than the gain of the system, the wireless relay apparatus 100 may operate normally and relay signals. Here, the sufficiently large degree may be changed depending on the type of the wireless signal and the required performance. When the feedback isolation is not sufficiently larger than the system gain, signal quality deteriorates or fine oscillation occurs, so that the wireless relay apparatus 100 does not normally relay signals. When the feedback isolation is equal to or smaller than the system gain, oscillation occurs, so that the wireless relay apparatus 100 does not normally relay signals.

Typically, since the wireless relay apparatus 100 is designed to have sufficient feedback isolation to the extent that oscillation does not occur internally, there are few cases where oscillation occurs due to a hardware problem of the wireless relay apparatus 100 itself. In most cases, the feedback isolation is lowered by a feedback path through which the output signal is input to the input antenna due to the external environment, and oscillation occurs due to this. Therefore, in order to prevent oscillation from occurring in the wireless relay apparatus 100, the external environment must be controlled so that the feedback isolation is not lowered. However, there are not many cases where control of the external environment is possible. For example, control of large trucks, birds, buildings and the like is impossible. In particular, when there are many external factors that may lower the feedback isolation, such as a narrow indoor space or an urban environment, normal operation of the wireless relay apparatus may be more difficult. In order to solve this problem, the frequency of the input signal and the frequency of the output signal may be made different in the wireless relay apparatus 100.

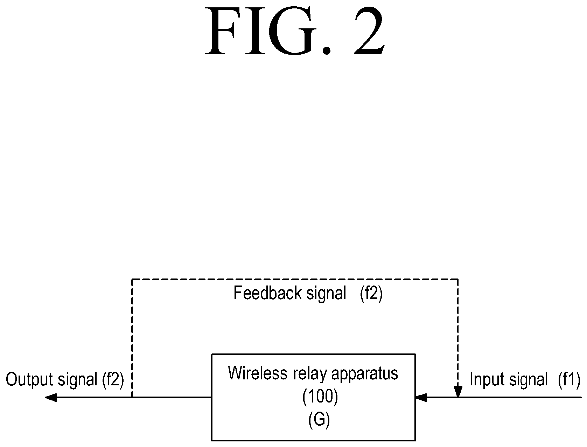

FIG. 2 is a diagram explaining a feedback signal and oscillation in a case where the frequencies of the input signal and the output signal of the wireless relay apparatus are different.

Referring to FIG. 2, the frequency of the input signal of the wireless relay apparatus 100 is f1, and the frequency of the output signal is set to f2. Since the feedback signal is a part of the output signal, the frequency of the feedback signal is f2. At this time, a filter is applied to the feedback signal returned to the input terminal in the wireless relay apparatus 100, so that the corresponding feedback signal can be removed. As the feedback signal is removed, an infinite loop does not occur, and therefore oscillation does not occur.

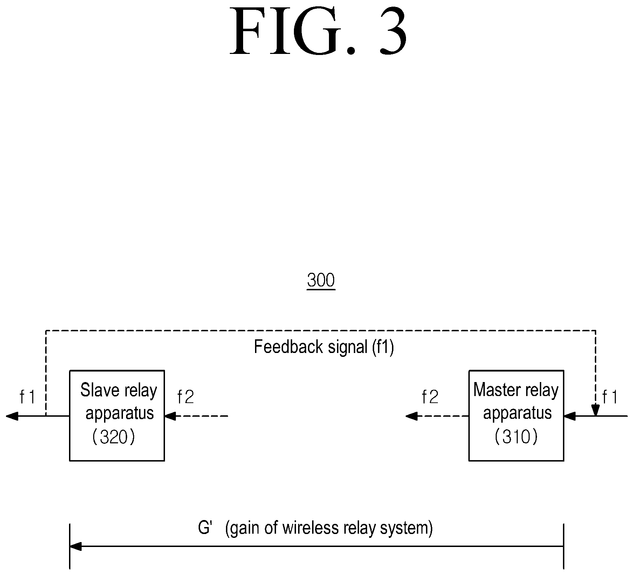

However, when the frequencies of the input signal and the output signal are different as shown in FIG. 2, it is necessary to restore the frequency f2 of the output signal to f1, which is the frequency of the input signal. Referring to FIG. 3, an example of a wireless relay apparatus which restores the frequency in a case where the frequencies of the input/output signals are different is described.

FIG. 3 is a diagram explaining a configuration of a wireless relay apparatus which restores the frequency of the output signal in a case where the frequencies of the input signal and the output signal are different.

Referring to FIG. 3, a wireless relay system 300 includes a master relay apparatus 310 and a slave relay apparatus 320. When the frequency of a signal input to the wireless relay system 300 is f1, the master relay apparatus 310 outputs a signal of frequency f2, which is a frequency different from f1, the frequency of the input signal. The slave relay apparatus 320 receives, as input, the signal of f2 output from the master relay apparatus 310, restores it to f1, and outputs it. The frequencies of the input signal and the output signal of the entire wireless relay system 300 are the same as f1, and a part of the output signal of the slave relay apparatus 320 may be input to the master relay apparatus 310 as a feedback signal. However, the wireless relay system 300 of FIG. 3 is composed of the master relay apparatus 310 and the slave relay apparatus 320, and when a considerable distance is placed between the output terminal of the slave relay apparatus 320 and the input terminal of the master relay apparatus 310, the feedback isolation between the output terminal of the slave relay apparatus 320 and the input terminal of the master relay apparatus 310 becomes considerably large. Since the wireless relay system 300 can greatly raise the feedback isolation in this way, the feedback isolation can be maintained high even in a case where it is affected by the external environment. Therefore, the feedback isolation can become much larger than the gain (G') of the wireless relay system, and accordingly, the frequencies of the input/output signals of the wireless relay system 300 are the same, but oscillation does not occur. However, such a wireless relay system 300 requires additional hardware by the pair of the master relay apparatus 310 and the slave relay apparatus 322, and there is a problem that communication is not performed in the section between the master relay apparatus 310 and the slave relay apparatus 322.

Hereinafter, a wireless relay apparatus according to an embodiment of the present invention is described.

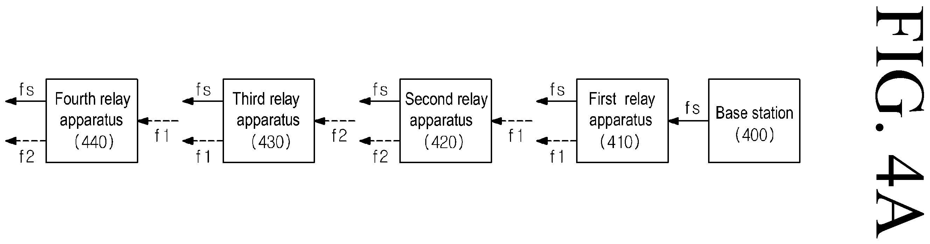

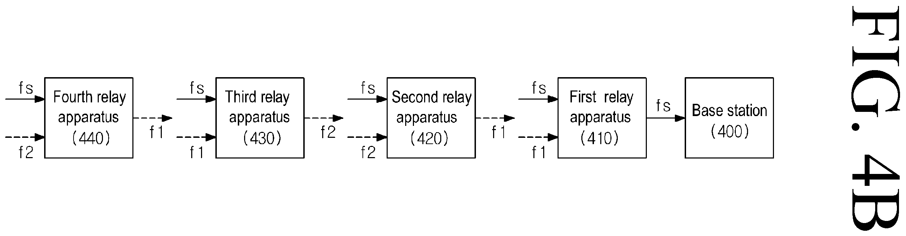

FIG. 4a and FIG. 4b are diagrams explaining a concept of wireless relaying according to an embodiment of the present invention.

FIG. 4a illustrates an example in which a signal transmitted from a base station is transferred in a forward direction (= downlink) through a plurality of relay apparatuses.

Referring to FIG. 4a, it is assumed that the base station 400 transmits a signal of a service frequency (fs), which is a frequency serviced in the corresponding communication system. The signal transmitted by the base station 400 may be transferred to terminals (not shown) through relay apparatuses, and in FIG. 4a, four relay apparatuses 410, 420, 430 and 440 were illustrated.

The first relay apparatus 410 may receive a signal of the service frequency (fs) as input and output a signal of the service frequency (fs). In addition, the first relay apparatus 410 may frequency-convert the signal of the service frequency (fs) and output a signal of a first frequency (f1) different from the service frequency (fs). The signal of the service frequency (fs) output by the first relay apparatus 410 may be transferred to terminals (not shown) located around the first relay apparatus 410. Meanwhile, the signal of the first frequency (f1) output by the first relay apparatus 410 becomes an input signal of the second relay apparatus 420, which is the relay apparatus of the next order.

The second relay apparatus 420 may receive the signal of the first frequency (f1) as input, frequency-convert it, and output a signal of the service frequency (fs). In addition, the second relay apparatus 420 may frequency-convert the signal of the first frequency (f1) and output a signal of a second frequency (f2) different from the first frequency (f1). The signal of the service frequency (fs) output by the second relay apparatus 420 may be transferred to terminals (not shown) located around the second relay apparatus 420. Meanwhile, the signal of the second frequency (f2) output by the second relay apparatus 420 becomes an input signal of the third relay apparatus 430, which is the relay apparatus of the next order.

The third relay apparatus 430 may receive the signal of the second frequency (f2) as input, frequency-convert it, and output a signal of the service frequency (fs). In addition, the third relay apparatus 430 may frequency-convert the signal of the second frequency (f2) and output a signal of the first frequency (f1). The signal of the service frequency (fs) output by the third relay apparatus 430 may be transferred to terminals (not shown) located around the third relay apparatus 430. Meanwhile, the signal of the first frequency (f1) output by the third relay apparatus 430 becomes an input signal of the fourth relay apparatus 440, which is the relay apparatus of the next order.

The operation of the fourth relay apparatus 440 is the same as the operation of the second relay apparatus 420 described above. That is, the fourth relay apparatus 440 may receive the signal of the first frequency (f1) as input, frequency-convert it, and output a signal of the service frequency (fs). In addition, the fourth relay apparatus 440 may frequency-convert the signal of the first frequency (f1) and output a signal of the second frequency (f2). The signal of the service frequency (fs) output by the fourth relay apparatus 440 may be transferred to terminals (not shown) located around the fourth relay apparatus 440. Meanwhile, the signal of the second frequency (f2) output by the fourth relay apparatus 440 may become an input signal of a relay apparatus (not shown) of the next order.

As such, in an embodiment of the present invention, each relay apparatus may frequency-convert the signal input to the corresponding relay apparatus and output one of frequencies (f1, f2) different from the service frequency (fs) used in the corresponding wireless communication system. The signals of the frequencies (f1, f2) different from the service frequency (fs) become input signals of other relay apparatuses. Since the other frequencies (f1, f2) become a connection link between the relay apparatuses, they may be referred to as 'link frequencies'. In FIG. 4a, it was described that the number of link frequencies is two, but the number of link frequencies may be two or more. For example, when the number of link frequencies is three, the first relay apparatus 410 may output f1, the second relay apparatus 420 may output f2, the third relay apparatus may output f3, and the fourth relay apparatus may output f1.

Meanwhile, when a wireless relay apparatus selects one of the link frequencies, the wireless relay apparatus may select a link frequency suitable for its surrounding environment in consideration of its surrounding environment (e.g., tunnel, indoor, etc.). Alternatively, candidates of link frequencies suitable for each wireless relay apparatus may be set in advance. For example, when the total link frequencies are four (f1, f2, f3, f4), the first wireless relay apparatus 410 may be set to select one of f1, f2, f3 and f4, the second wireless relay apparatus 420 may be set to select one of f2, f3 and f4, and the third wireless relay apparatus 430 and the fourth wireless relay apparatus 440 may be set to select one of f3 and f4.

FIG. 4b illustrates an example in which an uplink signal is transferred in a reverse direction (= uplink) through a plurality of relay apparatuses.

The fourth relay apparatus 440 may receive, as input, a signal of the service frequency (fs) transmitted by a surrounding terminal (not shown) and a signal of the second frequency (f2) output from another relay apparatus (not shown), frequency-convert each of them, and output a signal of the first frequency (f1). The signal of the first frequency (f1) output by the fourth relay apparatus 440 may become an input signal of the third relay apparatus 430, which is the relay apparatus of the next order.

The third relay apparatus 430 may receive, as input, a signal of the service frequency (fs) transmitted by a surrounding terminal (not shown) and the signal of the first frequency (f1) output from the fourth relay apparatus 440, frequency-convert each of them, and output a signal of the second frequency (f2). The signal of the second frequency (f2) output by the third relay apparatus 430 may become an input signal of the second relay apparatus 420, which is the relay apparatus of the next order.

The second relay apparatus 420 may receive, as input, a signal of the service frequency (fs) transmitted by a surrounding terminal (not shown) and the signal of the second frequency (f2) output from the third relay apparatus 430, frequency-convert each of them, and output a signal of the first frequency (f1). The signal of the first frequency (f1) output by the second relay apparatus 420 may become an input signal of the first relay apparatus 410, which is the relay apparatus of the next order.

The first relay apparatus 410 may receive, as input, a signal of the service frequency (fs) transmitted by a surrounding terminal (not shown) and the signal of the first frequency (f1) output from the second relay apparatus 420, frequency-convert each of them, and output a signal of the service frequency (fs). Since the signal output from the first relay apparatus 410 is directly transferred to the base station 400, the first relay apparatus 410 outputs a signal of the service frequency (fs), not the second frequency (f2), which is a link frequency. That is, since the first relay apparatus 410 is the last wireless relay apparatus on the reverse signal path transferred in the direction of the base station, the first relay apparatus 410 outputs a signal of fs, which is the service frequency.

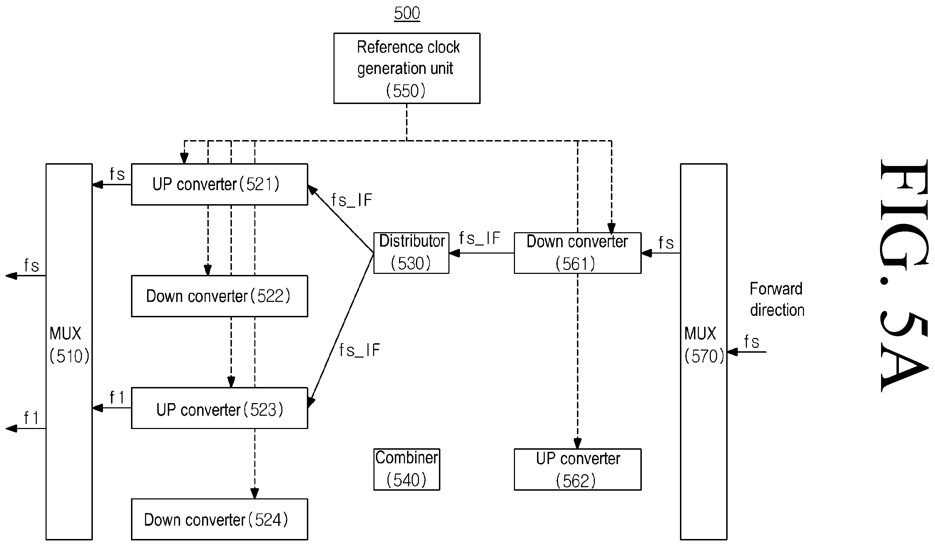

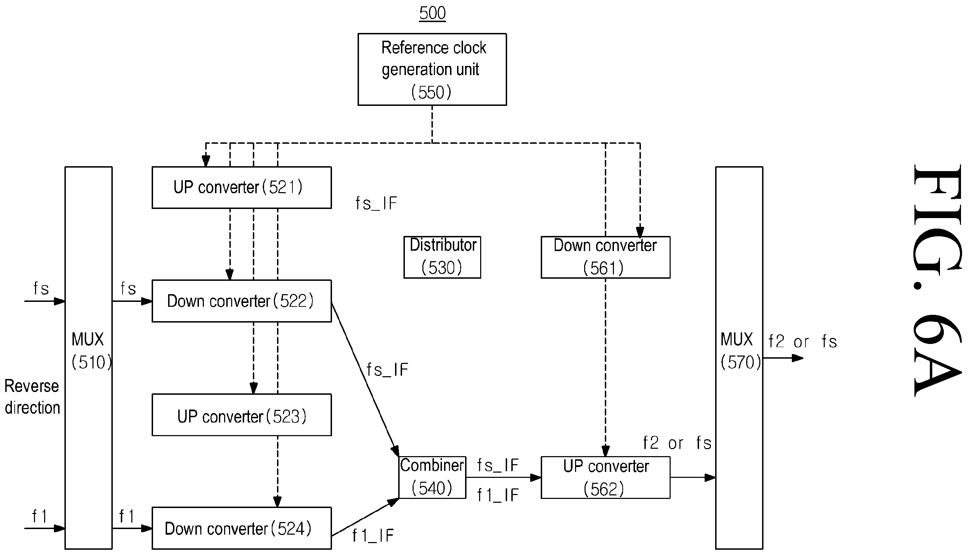

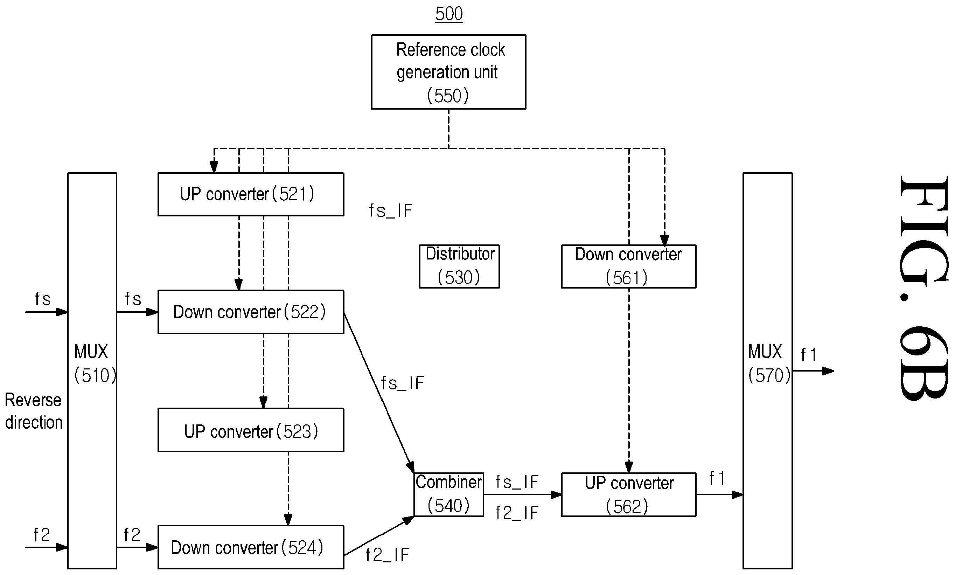

Hereinafter, with reference to FIG. 5a to FIG. 5d and FIG. 6a and FIG. 6b, the internal configuration and detailed operation of the wireless relay apparatus according to an embodiment of the present invention are described.

FIG. 5a is a diagram explaining a configuration of the wireless relay apparatus according to an embodiment of the present invention and an operation in a case where the input frequency in the forward direction is the service frequency.

The wireless relay apparatus 500 includes two multiplexers 510 and 570, up converters 521, 523 and 561 which perform frequency up-conversion, down converters 522, 524 and 562 which perform frequency down-conversion, a distributor 530 which distributes a signal, a combiner 540 which combines input signals and outputs them, and a reference clock generation unit 550 which generates a reference clock.

Hereinafter, the operation of the wireless relay apparatus 500 when the frequency of the input signal in the forward direction is the service frequency (fs) is described. The case where the frequency of the input signal is the service frequency (fs) may correspond to the operation of the first wireless relay apparatus 410 in FIG. 4a above.

The reference clock generation unit 550 supplies the same reference signal to the up converters 521, 523 and 562 and the down converters 522, 524 and 561. For reference, between a down converter and an up converter forming one pair (561/562, 521/522 and 523/524), a local signal generator may be used for each converter, or one local signal generator may be shared. This may be determined depending on the frequency of the intermediate frequency (Intermediate Frequency: IF) channel filter used. In FIG. 5a, it was assumed that local signal generators are provided inside the down converters and the up converters.

When the signal input through the multiplexer (Multiplexer: MUX) 570 is a signal of the service frequency (fs), the down converter (Down Converter) 561 down-converts the signal of the service frequency (fs) to an intermediate frequency (Intermediate Frequency: IF), and then outputs a signal of an intermediate frequency signal (fs_IF) including only the signal component of the service frequency (fs) by using a channel filter. The intermediate frequency signal (fs_IF) of the service frequency output from the down converter 561 is input to the distributor 530. The distributor 530 transfers the corresponding signal to the two up converters 521 and 523.

The up converter 521 frequency up-converts the intermediate frequency signal (fs_IF) of the service frequency into a service frequency (fs) signal, amplifies it, and transfers it to the multiplexer 510. In addition, the up converter 523 frequency up-converts the intermediate frequency signal (fs_IF) of the service frequency into a signal of the first frequency (f1), amplifies it, and outputs it to the multiplexer 510. The multiplexer 510 outputs the service frequency (fs) signal and the signal of the first frequency (f2).

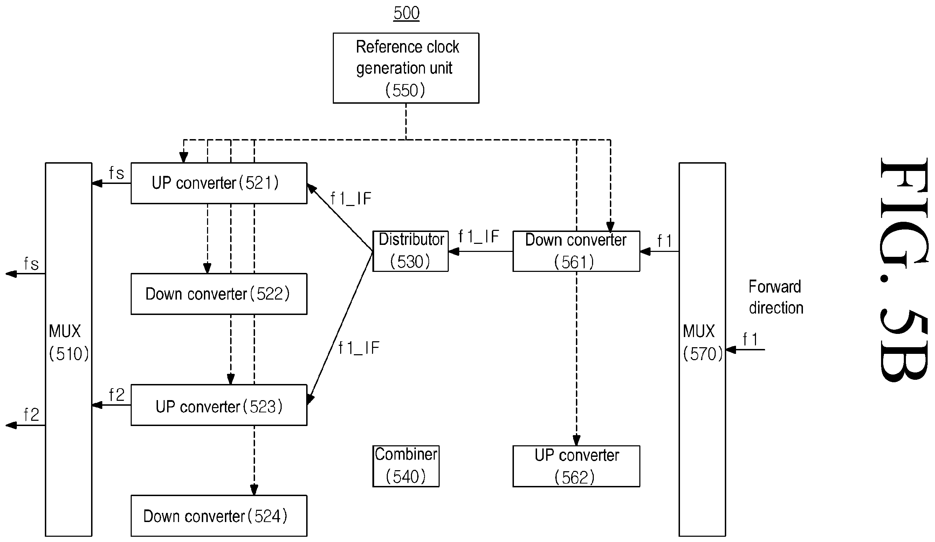

FIG. 5b is a diagram explaining an operation in a case where the input frequency in the forward direction in the wireless relay apparatus according to an embodiment of the present invention is the first frequency.

The operation of the wireless relay apparatus 500 of FIG. 5b may correspond to the operations of the second relay apparatus 420 and the fourth relay apparatus 440 whose input frequency is the first frequency (f1) in FIG. 4a.

When the signal input through the multiplexer (Multiplexer: MUX) 570 is a signal of the first frequency (f1), the down converter (Down Converter) 561 down-converts the signal of the first frequency (f1) to an intermediate frequency (Intermediate Frequency: IF), and then outputs a signal of an intermediate frequency signal (f1_IF) including only the signal component of the first frequency (f1) by using a channel filter. The intermediate frequency signal (f1_IF) of the first frequency output from the down converter 561 is input to the distributor 530. The distributor 530 transfers the corresponding signal to the two up converters 521 and 523.

The up converter 521 up-converts the intermediate frequency signal (f1_IF) of the first frequency into a service frequency (fs) signal, amplifies it, and transfers it to the multiplexer 510. In addition, the up converter 523 frequency up-converts the intermediate frequency signal (f1_IF) of the first frequency into a signal of the second frequency (f2), amplifies it, and outputs it to the multiplexer 510. The multiplexer 510 outputs the service frequency (fs) signal and the signal of the second frequency (f2).

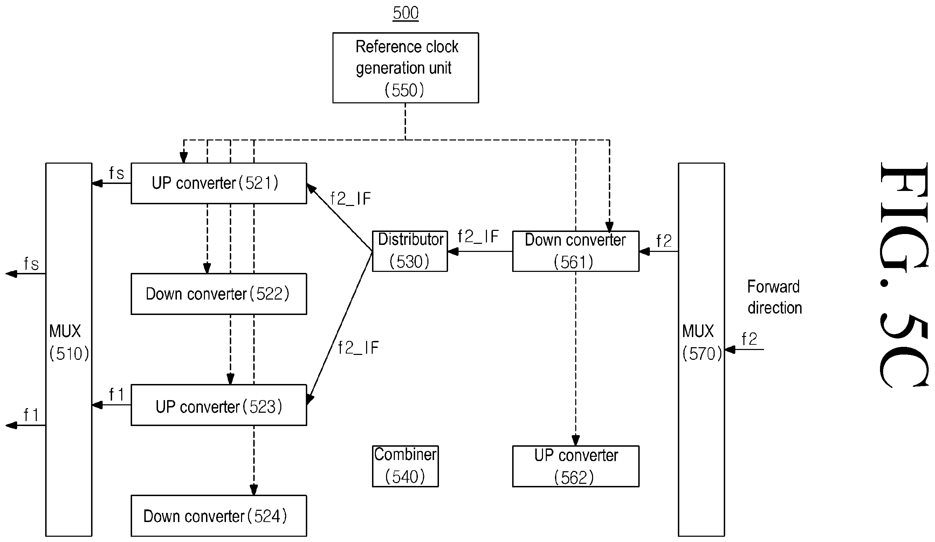

FIG. 5c is a diagram explaining an operation in a case where the input frequency in the forward direction in the wireless relay apparatus according to an embodiment of the present invention is the second frequency.

The operation of the wireless relay apparatus 500 of FIG. 5c may correspond to the operation of the third relay apparatus 430 whose input frequency is the second frequency (f2) in FIG. 4a.

When the signal input through the multiplexer (Multiplexer: MUX) 570 is a signal of the second frequency (f2), the down converter (Down Converter) 561 down-converts the signal of the second frequency (f2) to an intermediate frequency (Intermediate Frequency: IF), and then outputs a signal of an intermediate frequency signal (f2_IF) including only the signal component of the second frequency (f2) by using a channel filter. The intermediate frequency signal (f2_IF) of the second frequency output from the down converter 561 is input to the distributor 530. The distributor 530 transfers the corresponding signal to the two up converters 521 and 523.

The up converter 521 up-converts the intermediate frequency signal (f2_IF) of the second frequency into a service frequency (fs) signal, amplifies it, and transfers it to the multiplexer 510. In addition, the up converter 523 frequency up-converts the intermediate frequency signal (f2_IF) of the second frequency into a signal of the first frequency (f1), amplifies it, and outputs it to the multiplexer 510. The multiplexer 510 outputs the service frequency (fs) signal and the first frequency (f1) signal.

FIG. 6a is a diagram explaining an operation in a case where the input frequencies in the reverse direction in the wireless relay apparatus according to an embodiment of the present invention are the service frequency and the first frequency.

The operation of the wireless relay apparatus 500 of FIG. 6a may correspond to the operations of the third wireless relay apparatus 430 and the first relay apparatus 410 in which the frequencies of the input signals are the service frequency (fs) and the first frequency (f1) in FIG. 4b.

The signal of the service frequency (fs) input to the multiplexer 510 is transferred to the down converter 522, and the down converter 522 frequency down-converts the signal of the service frequency (fs) to an intermediate frequency (IF), passes only the signal of the service frequency component by using a channel filter, and outputs a signal of the intermediate frequency (fs_IF) of the service frequency. Thereafter, the intermediate frequency (fs_IF) signal of the service frequency is transferred to the up converter 562 through the combiner 540.

Meanwhile, the signal of the first frequency (f1) input through the multiplexer 502 is transferred to the down converter 524. The down converter 524 frequency down-converts the signal of the first frequency (f1) to an intermediate frequency (IF), passes only the signal of the first frequency (f1) component by using a channel filter, and outputs a signal of the intermediate frequency (f1_IF) of the first frequency. Thereafter, the signal of the intermediate frequency (f1_IF) of the first frequency is transferred to the up converter 562 through the combiner 540.

The up converter 562 frequency up-converts the intermediate frequency (fs_IF) signal of the service frequency and the signal of the intermediate frequency (f1_IF) of the first frequency each into a signal of the second frequency (f2), amplifies them, and outputs them to the multiplexer 570. If the output signal of the wireless relay apparatus 500 is directly transferred to the base station, that is, in a case where the wireless relay apparatus 500 corresponds to the first relay apparatus 410 of FIG. 4b, the up converter 562 frequency up-converts the intermediate frequency (fs_IF) signal of the service frequency and the signal of the intermediate frequency (f1_IF) of the first frequency each into a signal of the service frequency (fs), amplifies them, and outputs them to the multiplexer 570.

The multiplexer 570 outputs the signal of the second frequency (f2) or the signal of the service frequency (fs).

FIG. 6b is a diagram explaining an operation in a case where the input frequencies in the reverse direction in the wireless relay apparatus according to an embodiment of the present invention are the service frequency and the second frequency.

The operation of the wireless relay apparatus 500 of FIG. 6a may correspond to the operations of the fourth wireless relay apparatus 440 and the second relay apparatus 420 in which the frequencies of the input signals are the service frequency (fs) and the second frequency (f2) in FIG. 4b.

The signal of the service frequency (fs) input to the multiplexer 510 is transferred to the down converter 522, and the down converter 522 frequency down-converts the signal of the service frequency (fs) to an intermediate frequency (IF), passes only the signal of the service frequency component by using a channel filter, and outputs a signal of the intermediate frequency (fs_IF) of the service frequency. Thereafter, the intermediate frequency (fs_IF) signal of the service frequency is transferred to the up converter 562 through the combiner 540.

Meanwhile, the signal of the second frequency (f2) input through the multiplexer 502 is transferred to the down converter 524. The down converter 524 frequency down-converts the signal of the second frequency (f2) to an intermediate frequency (IF), passes only the signal of the second frequency (f2) component by using a channel filter, and outputs a signal of the intermediate frequency (f2_IF) of the second frequency. Thereafter, the signal of the intermediate frequency (f2_IF) of the second frequency is transferred to the up converter 562 through the combiner 540.

The up converter 102 frequency up-converts the intermediate frequency (fs_IF) signal of the service frequency and the signal of the intermediate frequency (f2_IF) of the second frequency each into a signal of the first frequency (f1), amplifies them, and outputs them to the multiplexer 570.

The multiplexer 570 outputs the signal of the first frequency (f2).

Meanwhile, although there may be differences in implementation depending on whether the duplex scheme used in the wireless communication system is FDD (Frequency Division Duplex) or TDD (Time Division Duplex), the basic structure of the wireless relay apparatus in both cases is the same as described above. In addition, the operation of the wireless relay apparatus according to an embodiment of the present invention may be implemented in the same manner not only in the analog domain (Analog domain) but also in the discrete time domain (Discrete Time domain).

The wireless relaying schemes described so far in FIG. 4a and FIG. 4b, FIG. 5a to FIG. 5d, and FIG. 6a and FIG. 6b assumed that two link frequencies (e.g., f1, f2) are used in the corresponding wireless communication system. In this case, if the frequency of the signal input to the wireless relay apparatus is the service frequency (fs), the corresponding wireless relay apparatus outputs a signal of the service frequency (fs) and a signal of the frequency of one of the two link frequencies (e.g., f1 or f2). If the frequency input to the corresponding wireless relay apparatus is one of the link frequencies (e.g., f1), the corresponding wireless relay apparatus outputs a signal of the service frequency (fs) and a signal of the frequency of another link frequency (f2) excluding the input link frequency.

If three or more link frequencies (e.g., f1, f2, f3) are used in the corresponding wireless communication system, when the frequency of the signal input to the corresponding wireless relay apparatus is the service frequency (fs), the wireless relay apparatus outputs a signal of the service frequency (fs) and a signal of the frequency of one of the three link frequencies (e.g., f1, f2 or f3). If the frequency input to the corresponding wireless relay apparatus is one of the link frequencies (e.g., f1), the corresponding wireless relay apparatus outputs a signal of the service frequency (fs) and a signal of the frequency of one (e.g., f2) of the other link frequencies excluding the input link frequency.

Hereinafter, the operation flow of the wireless relay apparatus according to an embodiment of the present invention is described.

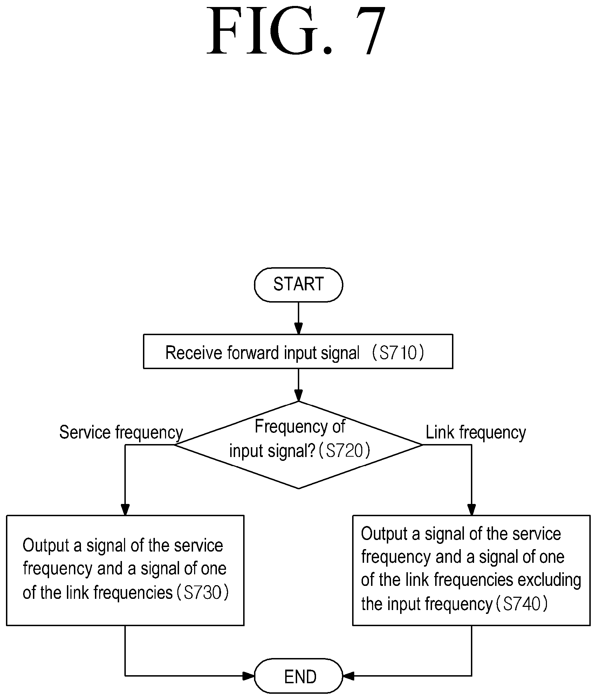

FIG. 7 is a diagram explaining an operation of a wireless relay apparatus which has received a forward signal according to an embodiment of the present invention.

Referring to FIG. 7, the wireless relay apparatus receives a forward (= downlink) input signal transmitted from the base station (S710). The wireless relay apparatus checks the frequency of the input signal (S720).

If the frequency of the input signal is the service frequency, the wireless relay apparatus outputs a signal of the service frequency and a signal of the frequency of one of the link frequencies (S730). For example, if the number of link frequencies is two (f1, f2), the wireless relay apparatus may select one frequency of f1 or f2 and output a signal of the selected link frequency.

If the frequency of the input signal is one of the plurality of preset link frequencies, the wireless relay apparatus outputs a signal of the service frequency and a signal of the frequency of one of the link frequencies excluding the input link frequency (S740). For example, if the number of link frequencies is two (f1, f2), the wireless relay apparatus may select one frequency of f1 or f2 and output a signal of the selected link frequency. If the number of link frequencies is three (f1, f2, f3), the wireless relay apparatus may select one frequency of f1, f2 or f3 and output a signal of the selected link frequency.

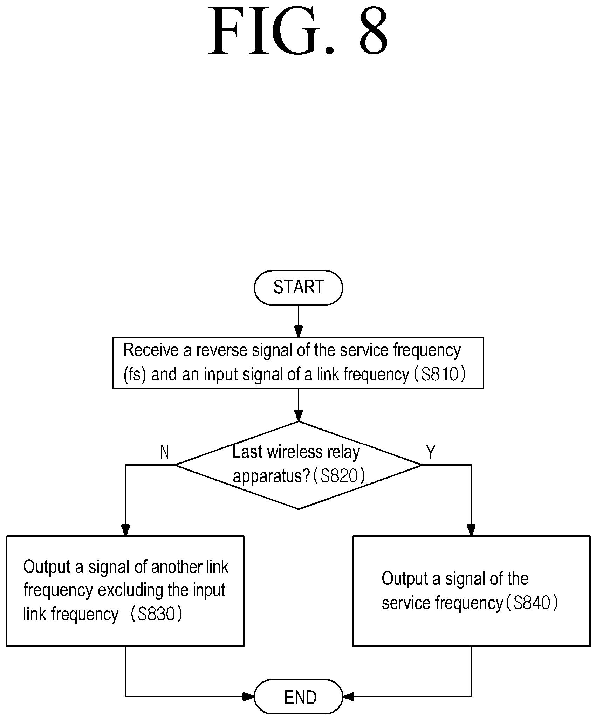

FIG. 8 is a diagram explaining an operation of a wireless relay apparatus which has received a reverse signal according to an embodiment of the present invention.

Referring to FIG. 8, the wireless relay apparatus receives a reverse (= uplink) input signal transmitted from a terminal and a signal of a link frequency transmitted by another wireless relay apparatus (S810). At this time, the frequency of the signal transmitted by the terminal is a signal of the service frequency (fs).

The wireless relay apparatus determines whether it is the last relay apparatus which relays a signal to the base station (S820). If the output signal of the corresponding wireless relay apparatus is directly transferred to the base station without relaying by another wireless relay apparatus, the corresponding wireless relay apparatus becomes the last wireless relay apparatus.

Whether it is the last relay apparatus may be determined based on the frequency of the downlink signal input to the wireless relay apparatus. That is, if the frequency of the downlink signal input to the wireless relay apparatus is the service frequency (fs), the corresponding wireless relay apparatus may determine that it is the last wireless relay apparatus. The fact that the frequency of the downlink signal input to the wireless relay apparatus is the service frequency (fs) means that the corresponding downlink signal is a signal directly received from the base station. This is because, therefore, the uplink signal will also be directly transmitted to the base station without relaying by another wireless relay apparatus.

If it is determined that it is not the last wireless relay apparatus, the corresponding wireless relay apparatus converts the input signal of the service frequency (fs) and the input signal of the link frequency each into another link frequency excluding the input link frequency and outputs the signals (S830). As one example, if the number of link frequencies is two (f1, f2) and a signal of the service frequency (fs) and a signal of the link frequency f1 were input to the wireless relay apparatus, the wireless relay apparatus converts the input signal of the service frequency (fs) and the signal of the link frequency (f1) into signals of f2, which is a link frequency that is not f1, and outputs them. As another example, if the number of link frequencies is three (f1, f2, f3) and a signal of the service frequency (fs) and a signal of the link frequency f1 were input to the wireless relay apparatus, the wireless relay apparatus converts the input signal of the service frequency (fs) and the signal of the link frequency (f1) into a signal of f2 or f3, which is one of the link frequencies (f2, f3) that are not f1, and outputs them.

If it is determined that it is the last wireless relay apparatus, the corresponding wireless relay apparatus outputs the input signal of the service frequency (fs) and the input signal of the link frequency each as a signal of the service frequency.

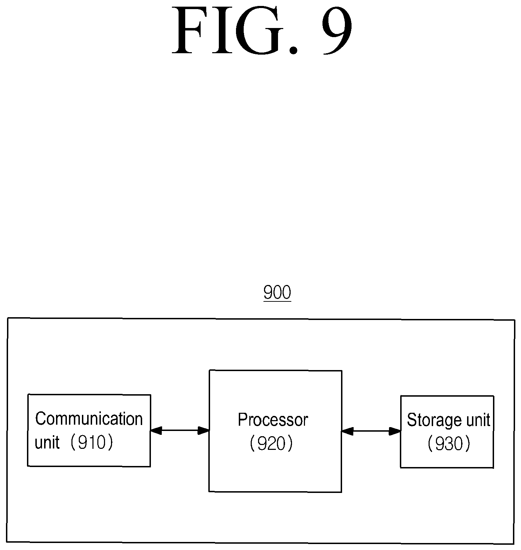

FIG. 9 is a diagram explaining a configuration of the wireless relay apparatus according to an embodiment of the present invention.

Referring to FIG. 9, the wireless relay apparatus 900 includes a communication unit 910, a processor 920 and a storage unit 930.

The storage unit 930 may store information, instructions and the like necessary for the operation of the wireless relay apparatus 900.

The communication unit 910 may include configurations such as those of FIG. 5a to FIG. 5d and FIG. 6a and FIG. 6b, and receives a signal from a base station, a terminal or another wireless relay apparatus, frequency-converts and amplifies the input signal, and generates an output signal.

The processor 920 controls the overall operation of the wireless relay apparatus 900. In particular, the processor 920 may control the communication unit 910 according to an embodiment of the present invention. Specifically, when the processor 920 receives a forward input signal transmitted from the base station, the processor 920 checks the frequency of the input signal. As a result of the check, if the frequency of the input signal is the service frequency, the processor 920 controls the communication unit 910 so that a signal of the service frequency and a signal of one of the link frequencies are output. If the frequency of the input signal is one of the link frequencies, the processor 920 controls the communication unit 910 so that a signal of the service frequency and a signal of the frequency of one of the link frequencies excluding the input link frequency are output.

In addition, when a reverse input signal transmitted from a terminal and a signal of a link frequency transmitted by another wireless apparatus are received, the processor 920 determines whether the corresponding wireless relay apparatus 900 is the last relay apparatus which relays a signal to the base station. If the output signal of the corresponding wireless relay apparatus 900 is directly transferred to the base station without relaying by another wireless relay apparatus, the corresponding wireless relay apparatus 900 becomes the last wireless relay apparatus.

As a result of the determination, if it is determined that it is not the last wireless relay apparatus, the processor 920 controls the communication unit 910 so that the input signal of the service frequency (fs) and the input signal of the link frequency are each output as signals converted into another link frequency excluding the input link frequency. As a result of the determination, if it is determined that it is the last wireless relay apparatus, the processor 920 controls the communication unit 910 so that the input signal of the service frequency (fs) and the input signal of the link frequency are each output as a signal of the service frequency.

The methods proposed in the present specification may also be performed, in addition to the communication apparatus described above, by at least one computer readable medium (computer readable medium) including an instruction (instruction) based on being executed by at least one processor (processor), and by an apparatus (apparatus) configured to control the wireless relay apparatus, including one or more processors and one or more memories which are executably connected by the one or more processors and store instructions, wherein the one or more processors execute the instructions to perform the methods proposed in the present specification.

The claims described in the present specification may be combined in various ways. For example, the technical features of the method claims of the present specification may be combined and implemented as an apparatus, and the technical features of the apparatus claims of the present specification may be combined and implemented as a method. In addition, the technical features of the method claims and the technical features of the apparatus claims of the present specification may be combined and implemented as an apparatus, and the technical features of the method claims and the technical features of the apparatus claims of the present specification may be combined and implemented as a method.

## Claims

1. A method of operating a wireless relay apparatus, the method comprising:
(a) receiving a downlink signal as input;
(b) determining a frequency of a first signal to be output as one link frequency, which is different from a frequency of the downlink signal, among a plurality of preset link frequencies; and
(c) outputting, by using the input downlink signal, a first signal having the determined link frequency and a second signal having a service frequency of a base station.

2. The method of operating a wireless relay apparatus of claim 1, wherein, in the step (b), if the frequency of the input downlink signal is the service frequency, the frequency of the first signal is determined as one of the plurality of preset link frequencies.

3. The method of operating a wireless relay apparatus of claim 2, wherein the step (c) comprises:
converting the downlink signal of the service frequency into a signal of an intermediate frequency;
frequency up-converting the converted signal of the intermediate frequency into the second signal of the service frequency; and
frequency up-converting the converted signal of the intermediate frequency into the first signal of the determined link frequency.

4. The method of operating a wireless relay apparatus of claim 1, wherein, in the step (b), if the frequency of the input downlink signal is one of the plurality of preset link frequencies, the frequency of the first signal is determined as one of link frequencies, which are not the frequency of the input downlink signal, among the plurality of preset link frequencies.

5. The method of operating a wireless relay apparatus of claim 4, wherein the step (c) comprises:
converting the input downlink signal into a signal of an intermediate frequency;
frequency up-converting the converted signal of the intermediate frequency into the second signal of the service frequency; and
frequency up-converting the converted signal of the intermediate frequency into the first signal of the determined link frequency.

6. A wireless relay apparatus comprising:
a communication unit which receives a downlink signal as input; and
a processor which determines a frequency of a first signal to be output as one link frequency, which is different from a frequency of the downlink signal, among a plurality of preset link frequencies, generates, by using the input downlink signal, a first signal having the determined link frequency and a second signal having a service frequency of a base station, and outputs the first signal and the second signal through the communication unit.

7. The wireless relay apparatus of claim 6, wherein the processor,
if the frequency of the input downlink signal is the service frequency, determines the frequency of the first signal as one of the plurality of preset link frequencies.

8. The wireless relay apparatus of claim 7, wherein the communication unit comprises:
a down converter which converts the downlink signal of the service frequency into a signal of an intermediate frequency;
a first up converter which frequency up-converts the converted signal of the intermediate frequency into the second signal of the service frequency; and
a second up converter which frequency up-converts the converted signal of the intermediate frequency into the first signal of the determined link frequency.

9. The wireless relay apparatus of claim 6, wherein the processor,
if the frequency of the input downlink signal is one of the plurality of preset link frequencies, determines the frequency of the first signal as one of link frequencies, which are not the frequency of the input downlink signal, among the plurality of preset link frequencies.

10. The wireless relay apparatus of claim 9, wherein the communication unit comprises:
a down converter which converts the input downlink signal into a signal of an intermediate frequency;
a first up converter which frequency up-converts the converted signal of the intermediate frequency into the second signal of the service frequency; and
a second up converter which frequency up-converts the converted signal of the intermediate frequency into the first signal of the determined link frequency.

11. A method of operating a wireless relay apparatus, the method comprising:
(a) receiving, as input, a first uplink signal of a service frequency of a base station and a second uplink signal of a first link frequency, which is one of a plurality of preset link frequencies, relayed from another relay apparatus;
(b) determining a frequency of an output signal based on whether the wireless relay apparatus is a last wireless relay apparatus; and
(c) generating an output signal of the determined frequency by using the first uplink signal and the second uplink signal,
wherein the last wireless relay apparatus directly transfers an output signal of the wireless relay apparatus to the base station without relaying by another wireless relay apparatus.

12. The method of operating a wireless relay apparatus of claim 11, wherein the step (b) comprises:
if the wireless relay apparatus is the last wireless relay apparatus, determining the frequency of the output signal as the service frequency.

13. The method of operating a wireless relay apparatus of claim 12, wherein the step (c) comprises:
converting the first uplink signal into a first intermediate signal of an intermediate frequency;
frequency up-converting the first intermediate signal into a signal of the service frequency;
converting the second uplink signal into a second intermediate signal of an intermediate frequency; and
frequency up-converting the second intermediate signal into a signal of the service frequency.

14. The method of operating a wireless relay apparatus of claim 11, wherein the step (b) comprises:
if the wireless relay apparatus is not the last wireless relay apparatus, determining the frequency of the output signal as a second link frequency, which is not the first link frequency, among the plurality of preset link frequencies.

15. The method of operating a wireless relay apparatus of claim 14, wherein the step (c) comprises:
converting the first uplink signal into a first intermediate signal of an intermediate frequency;
frequency up-converting the first intermediate signal into a signal of the determined second link frequency;
converting the second uplink signal into a second intermediate signal of an intermediate frequency; and
frequency up-converting the second intermediate signal into a signal of the determined second link frequency.

16. A wireless relay apparatus comprising:
a communication unit which receives, as input, a first uplink signal of a service frequency of a base station and a second uplink signal of a first link frequency, which is one of preset link frequencies, relayed from another relay apparatus; and
a processor which determines a frequency of an output signal based on whether the wireless relay apparatus is a last wireless relay apparatus, generates an output signal of the determined frequency by using the first uplink signal and the second uplink signal, and outputs the output signal through the communication unit,
wherein the last wireless relay apparatus directly transfers an output signal of the wireless relay apparatus to the base station without relaying by another wireless relay apparatus.

17. The wireless relay apparatus of claim 16, wherein the processor,
if the wireless relay apparatus is the last wireless relay apparatus, determines the frequency of the output signal as the service frequency.

18. The wireless relay apparatus of claim 17, wherein the communication unit comprises:
a first down converter which converts the first uplink signal into a first intermediate signal of an intermediate frequency;
an up converter which frequency up-converts the first intermediate signal into a signal of the service frequency;
a second down converter which converts the second uplink signal into a second intermediate signal of an intermediate frequency; and
the up converter which frequency up-converts the second intermediate signal into a signal of the service frequency.

19. The wireless relay apparatus of claim 16, wherein the processor,
if the wireless relay apparatus is not the last wireless relay apparatus, determines the frequency of the output signal as a second link frequency, which is not the first link frequency, among the plurality of preset link frequencies.

20. The wireless relay apparatus of claim 19, wherein the communication unit comprises:
a first down converter which converts the first uplink signal into a first intermediate signal of an intermediate frequency;
an up converter which frequency up-converts the first intermediate signal into a signal of the determined second link frequency;
a second down converter which converts the second uplink signal into a second intermediate signal of an intermediate frequency; and
the up converter which frequency up-converts the second intermediate signal into a signal of the determined second link frequency.
